**Europäisches Patentamt**

**European Patent Office**

**Office européen des brevets**

(19)

(11) Veröffentlichungsnummer : **0 356 667 B1**

(12) # EUROPÄISCHE PATENTSCHRIFT

(45) Veröffentlichungstag der Patentschrift :
**21.10.92 Patentblatt 92/43**

(51) Int. Cl.$^5$ : **B01D 35/18, F02M 37/22**

(21) Anmeldenummer : **89112648.4**

(22) Anmeldetag : **11.07.89**

(54) **Kraftstoffilter, insbesondere für Dieselmotoren, mit elektrischer Widerstandsheizung.**

(30) Priorität : **27.08.88 DE 3829126**

(43) Veröffentlichungstag der Anmeldung :
**07.03.90 Patentblatt 90/10**

(45) Bekanntmachung des Hinweises auf die
Patenterteilung :
**21.10.92 Patentblatt 92/43**

(84) Benannte Vertragsstaaten :
**DE ES FR GB IT SE**

(56) Entgegenhaltungen :
**US-A- 4 091 265**
**US-A- 4 321 136**

(73) Patentinhaber : **KNECHT FILTERWERKE GMBH**
**Pragstrasse 54**
**W-7000 Stuttgart 50 (DE)**

(72) Erfinder : **Gebert, Hans**
**Eppinger Strasse 64**
**W-7100 Heilbronn-Böckingen (DE)**
Erfinder : **Möhle, Rolf**
**Weinsberrger Strasse 8**
**W-7117 Bretzfeld-Scheppach (DE)**
Erfinder : **Müller, Hubert**
**Nägelesäcker 53**
**W-7000 Stuttgart 60 (DE)**

(74) Vertreter : **Dipl.-Phys.Dr. Manitz**
**Dipl.-Ing.Dipl.-Wirtsch.-Ing. Finsterwald**
**Dipl.-Phys. Rotermund Dipl.-Chem.Dr. Heyn**
**B.Sc.(Phys.) Morgan**
**Seelbergstrasse 23/25**
**W-7000 Stuttgart 50 (DE)**

**Beschreibung**

Kraftstoffilter, insbesondere für Dieselmotoren, mit elektrischer Widerstandsheizung

Die Erfindung betrifft ein Kraftstoffilter, insbesondere für Dieselmotoren, mit einem austauschbaren Filterteil, z.B. einer Filterpatrone, sowie einem dasselbe halternden Filterkopf, welcher einen Kraftstoffeinlaß bzw. einen daran anschließenden Eingangsbereich sowie einen damit über das Filterteil kommunizierenden Kraftstoffauslaß besitzt und eine zur Erwärmung des Kraftstoffes dienende elektrische Widerstandsheizung aufnimmt, die als PTC-Element (Element mit positivem Temperaturkoeffizienten), dessen elektrischer Widerstand oberhalb eines Temperaturschwellwertes stark ansteigt, ausgebildet und mittels eines im Filterkopf untergebrachten temperaturempfindlichen Elementes steuerbar ist.

Ein derartiges Kraftstoffilter wird in der EP-B 00 51 936 beschrieben.

Dieselkraftstoffe enthalten Bestandteile, wie Parafine, die bei tiefen Temperaturen zähflüssig bzw. fest werden, so daß der Dieselkraftstoff eine breiartige Konsistenz annimmt. Dies hat zur Folge, daß sich Kraftstoffilter, die üblicherweise zwischen dem Kraftstofftank und dem Motor in der Kraftstoffleitung angeordnet sind, leicht zusetzen können.

Um dies zu vermeiden, werden im Kraftstoffilter bzw. im Filterkopf desselben Heizungen angeordnet, welche üblicherweise als elektrische Widerstandsheizungen ausgebildet sind und aus Elementen mit ausgeprägt positivem Temperaturkoeffizienten aufgebaut sind. Derartige Elemente bestehen beispielsweise aus Bariumtitanat, welches mit Lanthaniden dotiert ist. Damit wird erreicht, daß der elektrische Widerstand dieser Elemente oberhalb eines Temperaturschwellwertes steil ansteigt, mit der Folge, daß die Heizleistung der Elemente oberhalb des Temperaturschwellwertes stark abfällt bzw. vernachlässigbar klein wird. Dementsprechend wird die Betriebssicherheit der Kraftstoffheizung im Kraftstoffilter auch dann gewährleistet, wenn das Filter, beispielsweise aufgrund einer Störung der Kraftstoffpumpe, frei von Kraftstoff sein bzw. bleiben sollte. Eine gefährliche Überhitzung kann also ausgeschlossen werden.

Für eine wirksame Erwärmung des Kraftstoffes im Kraftstoffilter werden große Heizleistungen benötigt. Aus diesem Grunde werden bisher zum Ein- und Ausschalten der Heizelemente Relais od.dgl. benutzt, die außerhalb des Filterkopfes angeordnet und mittels des temperaturempfindlichen Elementes gesteuert werden, welches dazu mit dem Relais über Steuerleitungen verbunden sein muß.

Abgesehen davon, daß Relais vergleichsweise störanfällige Bauteile darstellen, ist bei derartigen Anordnungen nachteilig, daß neben den Anschlußleitungen der Kraftstoffheizungen zusätzliche Steuerleitungen außerhalb des Kraftstoffilters installiert werden müssen.

Deshalb ist es Aufgabe der Erfindung, ein Kraftstoffilter mit elektrischer Widerstandsheizung zu schaffen, bei der alle zur Heizungssteuerung dienenden Elemente im Filterkopf untergebracht werden können.

Diese Aufgabe wird bei einem Kraftstoffilter der eingangs angegebenen Art erfindungsgemäß dadurch gelöst, daß das temperaturempfindliche Element direkt oder indirekt mit dem Steuereingang eines mit der Widerstandsheizung elektrisch in Reihe geschalteten kontaktlosen Halbleiter-Leistungsschalters, beispielsweise ein Transistor, verbunden ist, welcher sowohl mit dem den Filterkopf durchsetzenden Kraftstoff als auch mit der Widerstandsheizung thermisch gekoppelt bzw. wärmeleitend verbunden ist.

Wenn Halbleiter-Leistungsschalter starke elektrische Ströme steuern sollen, muß aufgrund der den Halbleiter-Leistungsschalter durchsetzenden starken elektrischen Ströme mit einer erheblichen Erwärmung des Halbleiter-Leistungsschalters gerechnet werden. Erfindungsgemäß ist nun vorgesehen, daß der Halbleiter-Leistungsschalter seine Wärme an den Kraftstoff abgibt, so daß die Anordnung von Kühlblechen od.dgl., wie sie bei luftgekühlten Halbleiter-Leistungsschaltern üblich und notwendig ist, erübrigt werden kann. Im Normalbetrieb wird also der Halbleiter-Leistungsschalter bei eingeschalteter elektrischer Widerstandsheizung durch den das Kraftstoffilter durchsetzenden Kraftstoff gekühlt, wobei der Halbleiter-Leistungsschalter als zusätzliches Heizelement wirkt.

Sollte die Kraftstoffzufuhr zum Kraftstoffilter unterbrochen sein und/oder der Filterkopf keinen Kraftstoff führen, so kann trotz der nun fehlenden Flüssigkeitskühlung durch den Kraftstoff kein kritischer Zustand entstehen. Die Abwärme des Halbleiter-Leistungsschalters überträgt sich nämlich auf die Heizelemente, welche bei Erreichen des Temperaturschwellwertes den elektrischen Strom begrenzen, bzw. - nahezu - abschalten, der die Heizelemente und den damit elektrisch in Reihe geschalteten Halbleiter-Leistungsschalter durchsetzt. Damit wird sowohl die Heizleistung der Heizelemente als auch die Abwärme des Halbleiter-Leistungsschalters auf ein zulässiges Maß begrenzt.

Die wärmeleitende Verbindung zwischen Halbleiter-Leistungsschalter und Heizelementen kann in einfachster Weise durch Gehäuseteile des Filterkopfes gewährleistet werden; Heizelemente und Halbleiter-Leistungsschalter brauchen also nur in gut wärmeleitendem Kontakt an einem wärmeleitenden Wandteil des Filterkopfes benachbart angeordnet zu werden.

Gemäß einer bevorzugten Ausführungsform ist als Halbleiter-Leistungsschalter ein Metall-Oxid-Silizium-Feldeffekt-Transistor (MOS-FET) angeordnet. Mit derartigen Elementen lassen sich auch große elektrische Ströme in gut reproduzierbarer Weise steuern.

Als temperaturempfindliches Element ist bevorzugt ein Heißleiter angeordnet, welcher mit einem elektrischen Widerstand in Reihe liegt, wobei die elektrische Spannung, welche an der aus dem Heißleiter und dem Widerstand gebildeten Reihenschaltung abfällt, durch eine parallel zur Reihenschaltung angeordnete Zenerdiode od.dgl. auf einen Wert begrenzt ist, welcher unter einem Normalwert einer Versorgungsspannung liegt. Zwischen dem Widerstand und dem Heißleiter ist der eine Eingang eines Komporators angeschlossen, dessen anderer Eingang zwischen Widerständen einer von der Versorgungsspannung beaufschlagten elektrischen Widerstandsstrecke angeschlossen ist. Der Ausgang des Komparators ist an den Steuereingang des Halbleiter-Leistungsschalters gekoppelt, wobei der Halbleiter-Leistungsschalter seinen geöffneten Zustand, bei dem die Kraftstoffheizung abgeschaltet ist, einnimmt, solange der Ausgang des Komparators seinen einen Zustand (z.B. L) hat. Bei dieser Anordnung verändert sich die am einen Eingang des Komparators anliegende elektrische Spannung in Abhängigkeit von der Temperatur des Heißleiters, derart, daß unterhalb eines Schwellwertes der Temperatur am Heißleiter zwischen den Eingängen des Komparators eine Spannungsdifferenz in derjenigen Richtung vorliegt, bei der der Komparator den Ausgang auf den anderen Zustand (z.B. H) schaltet, wodurch der Halbleiter-Leistungsschalter die Kraftstoffheizung einzuschalten vermag.

Gleichzeitig arbeitet der Komparator auch als Schutzschalter für den Halbleiter-Leistungsschalter im Falle einer elektrischen Überspannung. Durch die Zenerdiode wird nämlich die Spannung am einen Eingang des Komparators begrenzt, während die Spannung am anderen Eingang des Komparators sich entsprechend der Abweichung der Versorgungsspannung von ihrem Normalwert verändert. Falls also in der Versorgungsspannung übermäßige Spannungsspitzen auftreten, stellt sich an den Eingängen des Komparators ebenfalls eine Spannungsdifferenz in derjenigen Richtung ein, bei der der Ausgang des Komparators auf den anderen Zustand (z.B. H) geschaltet wird und der Halbleiter-Leistungsschalter in seinen stromdurchlässigen Zustand umschalten kann. Damit wird einer Beschädigung des Halbleiter-Leistungsschalter bei Überspannung vorgebeugt.

Zweckmäßigerweise ist der Steuereingang des Halbleiter-Leistungsschalters zusätzlich mit dem Ausgang eines weiteren Komparators gekoppelt, dessen einer Eingang - z.B. durch Anschluß zwischen den Widerständen der von der Versorgungsspannung beaufschlagten Widerstandsstrecke - durch eine sich mit der Versorgungsspannung ändernde Spannung und dessen anderer Eingang mit einer - z.B. an einer Zenerdiode abfallenden - begrenzten Spannung beaufschlagt ist, wobei der Leistungsschalter nur dann unter Einschaltung der Kraftstoffheizung schließt, wenn die Ausgänge beider Komparatoren den einen Zustand (z.B. H) haben.

Durch den zustäzlichen Komparator wird bewirkt, daß die Kraftstoffheizung ausgeschaltet bleibt, wenn die Versorgungsspannung unter einen Mindestwert abfallen sollte. Wenn also beispielsweise die Batterie eines Kraftfahrzeuges schon stark entladen ist, so steht die gesamte Kapazität der Batterie zunächst für das Starten des Motors zur Verfügung, während dieser Phase bleibt die Kraftstoffheizung ausgeschaltet. Erst wenn sich bei laufendem Motor die Versorgungsspannung aufgrund eines vom Motor angetriebenen Generators erhöht, kann auch die Kraftstoffheizung einschalten.

Im übrigen gehen weitere bevorzugte Merkmale der Erfindung aus den Ansprüchen sowie der nachfolgenden Erläuterung einer bevorzugten Ausführungsform anhand der Zeichnung hervor.

Dabei zeigt

Fig. 1 ein schematisiertes Schnittbild eines Kraftstoffilters und

Fig. 2 einen Schaltplan der Kraftstoffheizung sowie der zugeordneten Steuerschaltung.

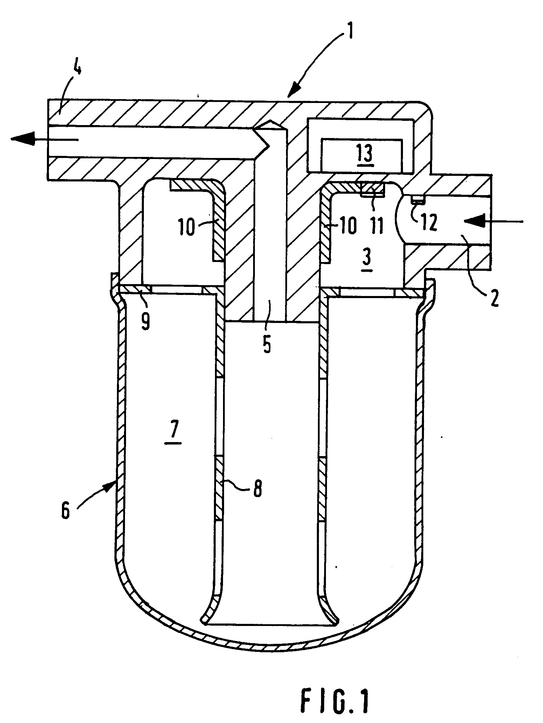

Der in Fig. 1 dargestellte Kraftstoffilter besitzt einen Filterkopf 1 mit einem Eingangsanschluß 2, welcher in einen ringförmigen Eingangsbereich 3 mündet, sowie einem Ausgangsanschluß, welcher von einer Zentralbohrung 5 des Filterkopfes 1 abzweigt. Am Filterkopf 1 ist eine Filterpatrone 6 gehaltert, deren Filtermedium 7 eine zylindrische Lochwand 8 umschließt und nach oben durch eine radiale Lochwand 9 abgedeckt ist.

Der durch den Eingangsanschluß 2 zugeführte Kraftstoff, beispielsweise Dieselöl, gelangt also vom Eingangsbereich 3 durch die Lochwand 9 in das Filtermedium 7 der Filterpatrone 6 und tritt aus dem Filtermedium 7 durch die Lochwand 8 hindurch zur Zentralbohrung 5 aus, von wo er dann durch den Ausgangsanschluß 4 zum nicht dargestellten Motor geführt wird.

Falls bei niedriger Temperatur Bestandteile des Dieselöles feste Partikel bilden, besteht die Gefahr, daß der Filter verstopft. Um dies zu vermeiden, sind im Eingangsbereich 3 elektrische Widerstandsheizelemente 10 angeordnet, welche mittels eines Halbleiter-Leistungsschalters 11 ein- und ausgeschaltet werden. Die Heizelemente 10 sind als PTC-Elemente ausgebildet, deren elektrischer Widerstand oberhalb eines Schwellwertes der Temperatur steil ansteigt, so daß der die Heizelemente 10 durchsetzende elektrische Strom unter entsprechend starker Drosselung der Heizleistung vermindert bzw. nahezu unterbrochen wird, wenn die Temperatur der Heizelemente 10 den Temperatur-Schwellwert überschreitet. Dementsprechend können sich die Heizelemente 10 auch dann nicht überhitzen, wenn aufgrund einer Betriebsstörung im Kraftstoffsystem kein Kraftstoff in den Filterkopf 1 gelangt.

Bei eingeschalteten Heizelementen 10 erwärmt sich der mit den Heizelementen 10 elektrisch in Reihe liegende Halbleiter-Leistungsschalter ebenfalls, da der Halbleiter-Leistungsschalter 11 aufgrund seines relativ großen elektrischen Widerstandes als elektrische Widerstandsheizung wirkt. Um eine Überhitzung des Halbleiter-Leistungsschalters 11 zu vermeiden, ist derselbe so angeordnet, daß er vom Kraftstoff gekühlt wird.

Im übrigen steht der Halbleiter-Leistungsschalter 11 über einem gemeinsamen Metallträger und/oder über massive Wandteile des Filterkopfes 1 in wärmeleitender Verbindung mit den Heizelementen 10. Sollte die Heizung eingeschaltet sein, wenn sich kein Kraftstoff im Filterkopf 1 befindet, so erwärmen sich die Heizelemente 10 und der Halbleiter-Leistungsschalter 11 gegenseitig durch Wärmekopplung über den Metallträger bzw. die Wandteile, d.h. die Heizelemente 10 und der Halbleiter-Leistungsschalter 11 haben immer etwa gleiche Temperatur. Sobald dann der Temperatur-Schwellwert erreicht ist, bei dem der elektrische Widerstand der Heizelemente 10 stark ansteigt, wird die Stärke des die Heizelemente 10 und den Halbleiter-Leistungsschalter 11 durchsetzenden elektrischen Stromes entsprechend stark abgesenkt, so daß eine weitere Erwärmung der Heizelemente 10 und des Halbleiter-Leistungsschalters vorgebeugt wird.

Der Halbleiter-Leistungsschalter 11 wird mittels eines temperaturempfindlichen Elementes 12 gesteuert, welches als sogenannter Heißleiter ausgebildet ist. Dabei handelt es sich um ein von elektrischem Strom durchflossenes Element, dessen elektrischer Widerstand oberhalb einer Temperaturstelle stark abfällt. Das Element 12 wird vom Kraftstoff im Filterkopf 1 beaufschlagt. Der Heißleiter 12 bildet einen Teil einer Steuer- und Versorgungsschaltung 13 der Heizelemente 10. Die Schaltung 13 ist in einer Kammer 14 des Filterkopfes 1 untergebracht und wird über Anschlußklemmen 15 od.dgl. elektrisch mit einer nicht dargestellten Batterie od.dgl. eines Kraftfahrzeuges verbunden.

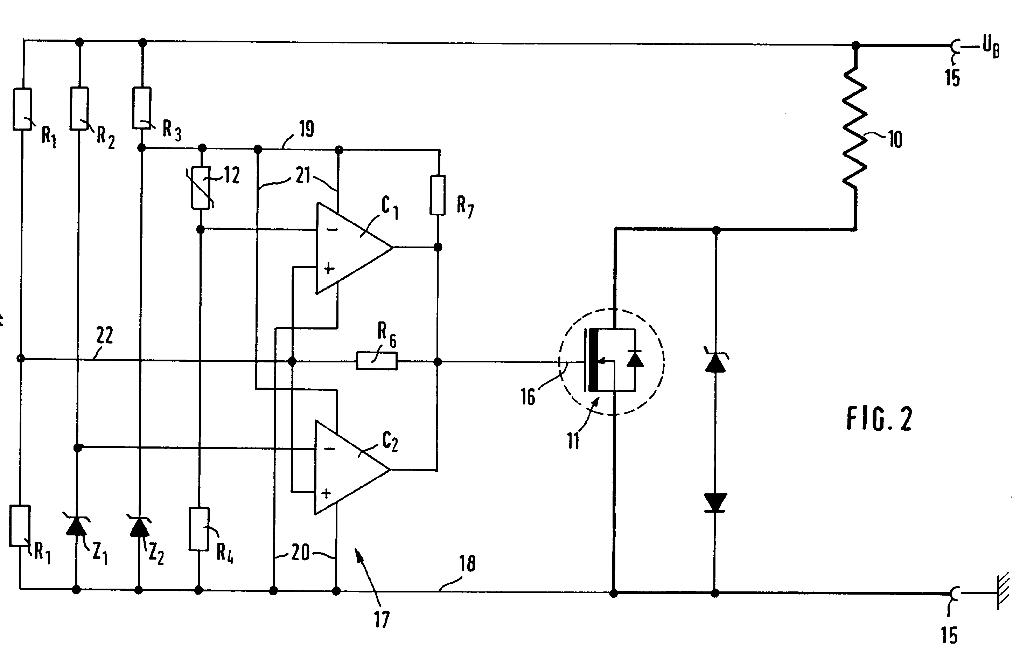

Die Steuer- und Versorgungsschaltung 13 ist in Figur 2 genauer dargestellt.

Die eine Anschlußklemme 15 liegt am Masseanschluß der Batterie, so daß an der anderen Anschlußklemme 15 die Batteriespannung $U_B$ ansteht.

Zwischen den Anschlußklemmen 15 liegen die Heizelemente 10 und der Halbleiter-Leistungsschalter 11 elektrisch in Reihe. Sobald also der Halbleiter-Leistungsschalter 11 seinen leitenden Zustand einnimmt, werden die Heizelemente 10 und der Halbleiter-Leistungsschalter 11 von gleich großen elektrischen Strömen durchsetzt.

Der Halbleiter-Leistungsschalter 11 besteht im wesentlichen aus einem Metall-Oxid-Silizium-Feldeffekt-Transistor (MOS-FET), welcher leitend wird, wenn an seinem Steuereingang 16 eine hinreichend große elektrische Spannung (Steuerspannung) anliegt.

Zur Erzeugung dieser Steuerspannung dient der Schaltungsblock 17.

Zwischen den Anschlußklemmen 15 ist eine Widerstandsstrecke geschaltet, die aus zwei Widerstän-den $R_1$ besteht, dementsprechend ist zwischen den beiden Widerständen $R_1$ jeweils die halbe Batterie-spannung ($U_B/2$) abgreifbar.

Parallel zu der aus den Widerständen $R_1$ beste-henden Widerstandsstrecke liegt eine aus dem Wi-derstand $R_2$ und der Zenerdiode $Z_1$ bestehende Rei-henschaltung. Die Zenerdiode $Z_1$ wird bei einer elek-trischen Spannung leitend, die etwas unterhalb der Hälfte der normalen Batteriespannung liegt. Dementsprechend kann zwischen dem Widerstand $R_2$ und der Zenerdiode $Z_1$ jeweils eine Spannung abgegriffen werden, welche geringer ist als die halbe normale Batteriespannung.

Des weiteren liegt parallel zu der aus den Wider-ständen $R_1$ bestehenden Widerstandsstrecke eine Reihenschaltung, welche aus dem Widerstand $R_3$ und der Zenerdiode $Z_2$ besteht. Die Zenerdiode $Z_2$ wird bei einer Spannung leitend, die etwas geringer als die normale Batteriespannung ist. Dementsprechend kann zwischen dem Widerstand $R_3$ und der Ze-nerdiode $Z_2$ bei hinreichend großer Batteriespannung immer eine im wesentlichen konstante Spannung abgegriffen werden, die etwas unterhalb der normalen Batteriespannung liegt.

Parallel zur Zenerdiode $Z_2$ ist eine Reihenschal-tung angeordnet, welche aus einem Widerstand $R_4$ und dem Heißleiter 12 besteht. Letzterer hat bei geringer Temperatur einen hohen und oberhalb eines Schwellwertes der Temperatur einen sehr geringen Widerstand. Dabei sind der Widerstand $R_4$ und der Heißleiter 12 derart bemessen, daß bei geringer Tem-peratur zwischen dem Widerstand $R_4$ und dem Heiß-leiter 12 eine Spannung abgreifbar ist, deren Wert unterhalb der Hälfte der normalen Batteriespannung liegt. Sobald der Schwellwert der Temperatur am Heißleiter 12 überschritten wird, ist zwischen dem Wi-derstand $R_4$ und dem Heißleiter 12 eine Spannung abgreifbar, welche deutlich größer als die halbe Batteriespannung ist.

Parallel zum Heißleiter 12 und zum Widerstand $R_4$, d.h. zwischen der Masseleitung 18 und einer zwi-schen der Zenerdiode $Z_2$ und dem Widerstand $R_3$ angeschlossenen Leitung 19 sind zwei Komparatoren $C_1$ und $C_2$ mit ihren Versorgungsleitungen 20 und 21 angeschlossen.

Die nichtinvertierenden Eingänge (+) der Kompa-ratoren $C_1$ und $C_2$ sind über eine Leitung 22 zwischen

den Widerständen $R_1$ angeschlossen, d.h. die nichtinvertierenden Eingänge werden immer von der halben Batteriespannung beaufschlagt.

Der invertierende Eingang (-) des Komparators $C_1$ ist zwischen dem Heißleiter 12 und dem Widerstand $R_4$ angeschlossen. Dementsprechend wird dieser Eingang von einer Spannung beaufschlagt, die unterhalb der halben Batteriespannung liegt, wenn die Temperatur am Heißleiter 12 unterhalb eines Schwellwertes der Temperatur liegt. Oberhalb des Schwellwertes der Temperatur wird der invertierende Eingang des Komparators $C_1$ von einer oberhalb der halben Batteriespannung liegenden Spannung beaufschlagt.

Der invertierende Eingang des Komparators $C_2$ ist zwischen dem Widerstand $R_2$ und der Zenerdiode $Z_1$ angeschlossen und wird dementsprechend immer von einer durch die Zenerdiode $Z_1$ vorgegebenen Spannung beaufschlagt, welche unterhalb der halben normalen Batteriespannung liegt.

Die Ausgänge der Komparatoren $C_1$ und $C_2$ sind unmittelbar mit dem Steuereingang 16 des Halbleiter-Leistungsschalters 11 verbunden. Außerdem sind die Ausgänge der Komparatoren $C_1$ und $C_2$ über einen Widerstand $R_6$ mit ihren nichtinvertierenden Eingängen rückgekoppelt und mittels eines Widerstandes $R_7$ an die Leitung 19 angeschlossen.

Die Komparatoren $C_1$ und $C_2$ arbeiten wie folgt:

Wenn am nichtinvertierenden Eingang (+) der Komparatoren $C_1$ bzw. $C_2$ eine Spannung anliegt, die niedriger ist als die Spannung am invertierenden Eingang (-), so wird der Ausgang des jeweiligen Komparators $C_1$ bzw. $C_2$ auf Masse geschaltet; dies ist der Zustand L.

Wenn dagegen am nichtinvertierenden Eingang (+) eine größere Spannung als am invertierenden Eingang (-) anliegt, wird der Ausgang des jeweiligen Komparators von Masse abgetrennt, d.h. der Ausgang bildet eine "tote" Leitung; dies ist der Zustand H.

Der Halbleiter-Leistungsschalter 11 schließt den Stromweg zu der Heizung 10 nur dann, wenn die Ausgänge beider Komparatoren $C_1$ und $C_2$ ihren Zustand H haben, bei dem der Eingang 16 des Halbleiter-Leistungsschalters 11 über den Widerstand $R_7$ mit einer relativ hohen Spannung beaufschlagt wird.

Wenn jeder Ausgang der Komparatoren oder der Ausgang eines Komparators den Zustand L hat, d.h. an Masse angeschlossen ist, sperrt der Halbleiter-Leistungsschalter 11, weil auch der Eingang 16 an Masse angekoppelt ist; dementsprechend wird der Stromweg zur Heizung 10 unterbrochen.

Der Ausgang des Komparators $C_1$ wird auf den Zustand H gelegt, wenn am Heißleiter 12 eine Temperatur unterhalb eines Temperatur-Schwellwertes vorliegt.

Bei geringer Temperatur hat nämlich der Heißleiter 12 einen sehr hohen Widerstand, so daß zwischen dem Heißleiter 12 und dem Widerstand $R_4$, welcher im Vergleich zum Heißleiter einen geringen Widerstand hat, eine niedrige Spannung ansteht, welche geringer ist als die halbe Batteriespannung $U_B$, die zwischen den Widerständen $R_1$ abgegriffen und an den nichtinvertierenden Eingang des Komparators $C_1$ geleitet wird. Dementsprechend ist die am invertierenden Eingang anliegende Spannung geringer als die Spannung am nichtinvertierenden Eingang des Komparators $C_1$, so daß dessen Ausgang auf den Zustand H geschaltet wird.

Falls am Heißleiter 12 eine hohe Temperatur oberhalb des Temperatur-Schwellwertes vorliegt, hat der Heißleiter 12 nur einen sehr geringen elektrischen Widerstand, welcher im Vergleich zum Widerstand $R_4$ klein ist. Dementsprechend liegt zwischen dem Heißleiter 12 und dem Widerstand $R_4$ eine relativ hohe elektrische Spannung vor, welche jedenfalls größer ist als die halbe Batteriespannung $U_B$. Damit wird der invertierende Eingang des Komparators $C_1$ von einer größeren Spannung als der nichtinvertierende Eingang beaufschlagt. Bei hoher Temperatur am Heißleiter 12 wird daher der Ausgang des Komparators $C_1$ auf den Zustand L, d.h. auf Masse geschaltet.

Im übrigen wird der Ausgang des Komparators $C_1$ auch dann in dem Zustand H geschaltet, wenn in der Stromversorgung eine Überspannung auftritt, welche deutlich über der normalen Batteriespannung $U_B$ liegt.

Die Leitung 19 führt nämlich im Falle einer Überspannung aufgrund der Zenerdiode $Z_2$ jeweils eine im wesentlichen konstante Spannung, welche im wesentlichen derjenigen Spannung entspricht, bei der die Zenerdiode $Z_2$ durchlässig wird; dies ist, wie oben ausgeführt wurde, eine Spannung etwas unterhalb der normalen Batteriespannung $U_B$. Damit wird auch die zwischen dem Heißleiter 12 und dem Widerstand $R_4$ abgreifbare Spannung nach oben begrenzt, welche an dem invertierenden Eingang des Komparators $C_1$ anliegt. Dagegen ist zwischen den Widerständen $R_1$ jeweils eine mit der Überspannung wachsende Spannung abgreifbar, deren Wert der Hälfte der an den Anschlüssen 15 anliegenden Überspannung entspricht. Bei größerer Überspannung liegt also am nichtinvertierenden Eingang des Komparators $C_1$ immer eine Spannung an, welche größer ist als die Spannung am invertierenden Eingang. Damit wird der Ausgang des Komparators $C_1$ im Falle von größeren Überspannungen auf den Zustand H geschaltet.

Der Ausgang des Komparators $C_2$ ist dauernd auf den Zustand H geschaltet, wenn an den Anschlüssen 15 die normale Batteriespannung anliegt. In diesem Falle wird nämlich zwischen den Widerständen $R_1$ die halbe normale Batteriespannung abgegriffen und über die Leitung 22 an den nichtinvertierenden Eingang des Komparators $C_2$ geleitet. Die am invertierenden Eingang des Komparators $C_2$ anliegende Spannung wird durch die Zenerdiode $Z_1$ auf einem Wert gehalten, welcher kleiner ist als die Hälfte der normalen Batteriespannung. Dementsprechend ist die am nichtinvertierenden Eingang anliegende Spannung größer als die Spannung am invertierenden Eingang, und der Ausgang des Komparators $C_2$ hat den Zustand H, d.h. er führt eine größere Spannung.

Sollte die an den Anschlußklemmen 15 anliegende Batteriespannung stark absinken, so sinkt auch die am nichtinvertierenden Eingang des Komparators $C_2$ anliegende Spannung entsprechend, welche über die Leitung 22 zwischen den Widerständen $R_1$ abgegriffen wird. Dagegen bleibt die am invertierenden Eingang des Komparators $C_2$ anliegende Spannung im wesentlichen konstant, d.h. diese Spannung wird durch die Zenerdiode $Z_1$ auf einem Wert etwas unterhalb der halben normalen Batteriespannung gehalten. Dementsprechend liegt bei einem Spannungsabfall zwischen den Anschlußklemmen 15 am invertierenden Eingang des Komparators $C_2$ eine größere Spannung an als am nichtinvertierenden Eingang. Damit wird der Ausgang des Komparators $C_2$ auf den Zustand L umgeschaltet, d.h. an Masse angelegt.

Aufgrund des Komparators $C_2$ kann also die Heizung 10 nicht eingeschaltet werden, wenn die an den Anschlüssen 15 anliegende elektrische Spannung unter einen vorgegebenen Minimalwert abfällt.

Sobald dieser Minimalwert überschritten wird, wird das Einund Ausschalten der Heizung 10 durch den Komparator $C_1$ gesteuert. Dabei wird die Heizung 10 eingeschaltet, wenn am Heißleiter 12 eine Temperatur unterhalb des Temperatur-Schwellwertes vorliegt.

Außerdem wird die Heizung 10 zur Überlastsicherung des Halbleiter-Leistungsschalters 11 durch den Komparator $C_1$ dann eingeschaltet, wenn an den Anschlußklemmen 15 eine kritische Überspannung auftritt. Die dabei die Heizung 10 und den Halbleiter-Leistungsschalter 11 durchsetzenden elektrischen Ströme werden dabei gegebenenfalls begrenzt, sobald die PTC-Elemente der Heizung 10 eine Grenztemperatur erreichen, bei der der elektrische Widerstand der Heizung 10 sprunghaft ansteigt.

Die Komparatoren $C_1$ und $C_2$, welche in der Regel als integrierte Schaltungen, d.h. als IC-Elemente ausgebildet sind, werden durch die Zenerdiode $Z_2$ gegen Beaufschlagung mit Überspannung gesichert. Die Zenerdiode $Z_2$ begrenzt nämlich die Spannungsdifferenz zwischen den Leitungen 18 und 19, über die die Komparatoren $C_1$ und $C_2$ versorgt werden.

Sollten die Anschlußklemmen 15 versehentlich falsch gepolt werden, dann fließt durch den Halbleiter-Leistungsschalter zumindest dann ein Strom, wenn derselbe als MOS-FET ausgebildet ist. Dabei wird eine Überhitzung des Halbleiter-Leistungsschalters in jedem Falle dadurch vermieden, daß eine Erwärmung des Halbleiter-Leistungsschalters 11 auch eine entsprechende Erwärmung der PCT-Elemente der Heizung 10 zur Folge hat, so daß der den Halbleiter-Leistungsschalter durchsetzende Strom in jedem Falle begrenzt wird, sobald die Temperatur der Heizung den Grenzwert erreicht hat, bei dem der elektrische Widerstand der Heizung 10 sprunghaft ansteigt.

Abweichend von der oben beschriebenen Ausführungsform können die Heizelemente 10 und der Halbleiter-Leistungsschalter 11 auch miteinander verlötet sein, um die gewünschte Wärmekopplung zwischen diesen Elementen zu gewährleisten.

## Patentansprüche

1. Kraftstoffilter, insbesondere für Dieselmotoren, mit einem austauschbaren Filterteil, z.B. einer Filterpatrone (6), sowie einem dasselbe halternden Filterkopf (1), welcher einen Kraftstoffeinlaß (2) bzw. einen daran anschließenden Eingangsbereich (3) sowie einen damit über das Filterteil kommunizierenden Kraftstoffauslaß (4) besitzt und eine im Eingangsbereich befindliche zur Erwärmung des Kraftstoffes dienende elektrische Widerstandsheizung (10) aufnimmt, die als PTC-Element, dessen elektrischer Widerstand oberhalb eines Temperaturschwellwertes sprunghaft ansteigt, ausgebildet und mittels eines im Filterkopf (1) untergebrachten, vom einfließenden Kraftstoff beaufschlagten, temperaturempfindlichen Elementes steuerbar ist, dadurch gekennzeichnet, daß das temperaturempfindliche Element (Heißleiter 12) direkt oder indirekt mit dem Steuereingang eines mit der Widerstandsheizung (10) elektrisch in Reihe geschalteten kontaktlosen Halbleiter-Leistungsschalters (Transistor 11) verbunden ist, welcher sowohl mit dem den Filterkopf (1) durchsetzenden Kraftstoff als auch mit der Widerstandsheizung (10) thermisch gekoppelt bzw. wärmeleitend verbunden ist.

2. Kraftstoffilter nach Anspruch 1, dadurch gekennzeichnet, daß der Halbleiter-Leistungsschalter (11) und die Widerstandsheizung (10) auf einem gemeinsamen Metallträger in wärmeleitender Verbindung miteinander angeordnet sind.

3. Kraftstoffilter nach einem der Ansprüche 1 oder 2, dadurch gekennzeichnet, daß als Halbleiter-Leistungsschalter (11) ein Metall-Oxid-Silizium-Feldeffekt-Transistor (MOS-FET) angeordnet ist.

4. Kraftstoffilter nach einem der Ansprüche 1 bis 3, dadurch gekennzeichnet, daß als temperaturempfindliches Element ein Heißleiter (12) angeordnet ist, welcher mit einem Widerstand ($R_4$) in Reihe liegt, wobei die elektrische Spannung, welche an der aus dem Heißleiter (12) und dem Wi-

derstand ($R_4$) gebildeten Reihenschaltung abfällt, durch eine parallel zu dieser Reihenschaltung angeordnete Zenerdiode ($Z_2$) auf einen Wert begrenzt ist, welcher unter einem Normalwert einer Versorgungsspannung ($U_B$) liegt,

daß zwischen dem Widerstand ($R_4$) und dem Heißleiter (12) der eine Eingang eines Komperators ($C_1$) angeschlossen ist, dessen anderer Eingang zwischen Widerständen ($R_1$) einer von der Versorgungsspannung ($U_B$) beaufschlagten Widerstandsstrecke angeschlossen ist,

daß der Ausgang des Komperators ($C_1$) an den Steuereingang (16) des Halbleiter-Leistungsschalters (11) gekoppelt ist, und

daß der Halbleiter-Leistungsschalter (11) geöffnet bleibt (Heizung 10 abgeschaltet), solange der Ausgang des Komperators ($C_1$) seinen einen Zustand (L) hat.

5. Kraftstoffilter nach Anspruch 4, dadurch gekennzeichnet, daß der Steuereingang (16) des Halbleiter-Leistungsschalters (11) mit dem Ausgang eines weiteren Komperators ($C_2$) gekoppelt ist, dessen einer Eingang durch Anschluß zwischen den Widerständen ($R_1$) der von der Versorgungsspannung ($U_B$) beaufschlagten Widerstandsstrecke durch eine sich mit der Versorgungsspannung ändernde Spannung und dessen anderer Eingang mit einer an einer Zenerdiode ($Z_1$) abfallenden begrenzten Spannung beaufschlagt ist, und daß der Halbleiter-Leistungsschalter (11) nur dann schließt (Heizung 10 eingeschaltet), wenn die Ausgänge beider Komperatoren ($C_1,C_2$) den anderen Zustand (H) haben.

6. Kraftstoffilter nach einem der Ansprüche 4 und 5, dadurch gekennzeichnet, daß die Versorgungs-spannung der Komperatoren ($C_1,C_2$) durch eine Zenerdiode ($Z_2$) begrenzt ist.

7. Kraftstoffilter nach einem der Ansprüche 4 bis 6, dadurch gekennzeichnet, daß der Steuereingang (16) des Halbleiter-Leistungsschalters (11) über einen Widerstand ($R_6$) zwischen den Widerständen ($R_1$) einer mit der Versorgungsspannung ($U_B$) beaufschlagten Widerstandsstrecke verbunden ist, und daß der Ausgang des Komperators ($C_1$) bzw. die Ausgänge der Komperatoren ($C_1,C_2$) mit dem Steuereingang (16) des Halbleiter-Leistungsschalters (11) verbunden sind.

8. Kraftstoffilter nach einem der Ansprüche 1 bis 7, dadurch gekennzeichnet, daß sämtliche den Halbleiter-Leistungsschalter (11) steuernden elektrischen bzw. elektronischen Elemente im Filterkopf (1) untergebracht sind und über der Heizung (10) zugeordnete Anschlüsse (15) elektrisch versorgt werden.

9. Kraftstoffilter nach einem der Ansprüche 1 bis 8, dadurch gekennzeichnet, daß der Halbleiter-Leistungsschalter (11) mit der Widerstandsheizung (10) über Metallteile des Filterkopfes (1) wärmeleitend verbunden sind.

10. Kraftstoffilter nach einem der Ansprüche 1 bis 8, dadurch gekennzeichnet, daß der Filterkopf (1) aus Kunststoff besteht.

11. Kraftstoffilter nach einem der Ansprüche 1 bis 10, dadurch gekennzeichnet, daß die zur Kraftstoffheizung nutzbare Verlustleistung des Halbleiter-Leistungsschalters (11) größenordnungsmäßig bei etwa 10 % der Heizleistung der Widerstandsheizung (10) liegt.

12. Kraftstoffilter nach einem der Ansprüche 1 bis 11, dadurch gekennzeichnet, daß der Halbleiter-Leistungsschalter (11) und die Widerstandsheizung (10) und/oder ein dieselbe tragendes Metallteil miteinander zur thermischen Kopplung von Leistungsschalter (11) und Widerstandsheizung (10) verlötet sind.

## Claims

1. Fuel filter, especially for diesel engines, with an exchangeable filter part, for example a filter cartridge (6), as well as a filter head (1) holding the latter, which comprises a fuel inlet (2) or an adjoining inlet region (3) as well as a fuel outlet (4) communicating therewith by way of the filter part and receives electrical resistance heating (10) serving for heating the fuel, which is constructed as a PTC element, whereof the electrical resistance rises suddenly above a temperature threshold value and can be controlled by means of a temperature-sensitive element located in the filter head (1) and acted upon by the inflowing fuel, characterised in that the temperature-sensitive element (thermistor 12) is connected directly or indirectly to the control input of a non-contacting semiconductor circuit-breaker (transistor 11) connected in series electrically, which is thermally coupled or connected in a heat-conducting manner both to the fuel passing through the filter head (1) as well as to the resistance heating (10).

2. Fuel filter according to Claim 1, characterised in that the semiconductor circuit-breaker (11) and the resistance heating (10) are arranged in heat-conducting connection with each other on a common metal support.

3. Fuel filter according to one of Claims 1 or 2, characterised in that a metal-oxide-silicon field effect transistor (MOS-FET) is provided as the semiconductor circuit-breaker (11).

4. Fuel filter according to one of Claims 1 to 3, characterised in that provided as the temperature-sensitive element is a thermistor (12), which is connected in series with a resistor ($R_4$), the electrical voltage, which decreases at the series connection formed from the thermistor (12) and the resistor ($R_4$), is restricted by a Zener diode ($Z_2$) connected parallel to this series connection, to a value which is below a normal value of a supply voltage ($U_B$), that connected between the resistor ($R_4$) and the thermistor (12) is one input of a comparator ($C_1$), whereof the other input is connected between resistors ($R_1$) of a resistance section receiving the supply voltage ($U_B$), that the output of the comparator ($C_1$) is connected to the control input (16) of the semiconductor circuit-breaker (11), and that the semiconductor circuit-breaker (11) remains open (heating 10 switched off), as long as the output of the comparator ($C_1$) has its one state (L).

5. Fuel filter according to Claim 4, characterised in that the control input (16) of the semiconductor circuit-breaker (11) is connected to the output of a further comparator ($C_2$), whereof one input due to a connection between the resistors ($R_1$) of the resistance section receiving the supply voltage ($U_B$) receives a voltage varying with the supply voltage and whereof the other input receives a limited voltage decreasing at a Zener diode ($Z_1$), and that the semiconductor circuit-breaker (11) only closes (heating 10 switched on) when the outputs of both comparators ($C_1$, $C_2$) have the other state (H).

6. Fuel filter according to one of Claims 4 and 5, characterised in that the supply voltage of the comparators ($C_1$, $C_2$) is limited by a Zener diode ($Z_2$).

7. Fuel filter according to one of Claims 4 to 6, characterised in that the control input (16) of the semiconductor circuit-breaker (11) is connected by way of a resistor ($R_6$) between the resistors ($R_1$) of a resistance section receiving the supply voltage ($U_B$), and that the output of the comparator ($C_1$) or the outputs of the comparators ($C_1$, $C_2$) are connected to the control input (16) of the semiconductor circuit-breaker (11).

8. Fuel filter according to one of Claims 1 to 7, characterised in that all the electrical or electronic elements controlling the semiconductor circuit-breaker (11) are located in the filter head (1) and are supplied electrically by connections (15) associated with the heating (10).

9. Fuel filter according to one of Claims 1 to 8, characterised in that the semiconductor circuit-breaker (11) is connected in a heat-conducting manner to the resistance heating (10) by way of metal parts of the filter head (1).

10. Fuel filter according to one of Claims 1 to 8, characterised in that the filter head (1) consists of synthetic material.

11. Fuel filter according to one of Claims 1 to 10, characterised in that the power loss of the semiconductor circuit-breaker (11) able to be used for heating fuel is in the order of magnitude of approximately 10% of the heating power of the resistance heating (10).

12. Fuel filter according to one of Claims 1 to 11, characterised in that the semiconductor circuit-breaker (11) and the resistance heating (10) and/or a metal part supporting the latter are soldered to each other for the thermal coupling of the circuit-breaker (11) and resistance heating (10).

## Revendications

1. - Filtre à carburant, en particulier pour des moteurs Diesel, comprenant un élément filtrant interchangeable, par exemple une cartouche filtrante (6), ainsi qu'une tête de filtre (1) qui supporte ce dernier et comporte une entrée de carburant (2) et respectivement, en aval, une section d'entrée (3), ainsi qu'une sortie de carburant (4) qui communique avec cette dernière par l'intermédiaire de l'élément filtrant et reçoit, dans la section d'entrée, un chauffage électrique par effet Joule (10) destiné à échauffer le carburant et conformé en élément PTC dont la résistance électrique augmente brusquement au-delà d'une valeur de seuil de température et qui peut être commandé au moyen d'un élément thermosensible logé dans la tête de filtre (1) et sollicité par le carburant arrivant, **caractérisé en ce** que l'élément thermosensible (thermistor 12) est relié directement ou indirectement à l'entrée de commande d'un sectionneur de puissance sans contact à semiconducteur (transistor 11) monté électriquement en série avec le chauffage par effet Joule (10), qui est couplé thermiquement ou de manière thermoconductrice avec le carburant traversant la tête de filtre (1) aussi bien qu'avec le chauffage par effet Joule (10).

2. - Filtre à carburant selon la revendication 1, caractérisé en ce que le sectionneur de puissance à semiconducteur (11) et le chauffage par effet Joule (10) sont montés, en liaison thermoconductrice, sur un support métallique commun.

3. - Filtre à carburant selon l'une des revendications 1 ou 2, caractérisé en ce que le sectionneur de puissance à semiconducteur (11) est un transistor MOS à effet de champ (MOS-FET).

4. - Filtre à carburant selon l'une des revendications 1 à 3, caractérisé en ce que l'élément thermosensible est un thermistor (12) qui est monté en série avec une résistance ($R_4$), la tension électrique qui chute sur le montage en série constitué par le thermistor (12) et la résistance ($R_4$) étant limitée par une diode Zener ($Z_2$) montée en parallèle avec ledit montage en série, à une valeur qui est inférieure à la valeur normale d'une tension d'alimentation ($U_B$); qu'entre la résistance ($R_4$) et le thermistor (12) est connectée l'une des entrées d'un comparateur ($C_1$) dont l'autre entrée est connectée entre les résistances ($R_1$) d'une section de résistance à laquelle est appliquée la tension d'alimentation ($U_B$); que la sortie du comparateur ($C_1$) est reliée à l'entrée de commande (16) du sectionneur de puissance à semiconducteur (11), et que le sectionneur de puissance à semiconducteur (11) reste ouvert (chauffage 10 arrêté) aussi longtemps que la sortie du comparateur ($C_1$) se trouve à l'état (L).

5. - Filtre à carburant selon la revendication 4, caractérisé en ce que l'entrée de commande (16) du sectionneur de puissance à semiconducteur (11) est couplée avec la sortie d'un autre comparateur ($C_2$) à l'une des entrées duquel est appliquée, par le raccordement entre les résistances ($R_1$) de la section de résistance à laquelle est appliquée la tension d'alimentation ($U_B$), une tension qui varie avec la tension d'alimentation, et à l'autre entrée duquel est appliquée une tension limitée qui chute sur la diode Zener ($Z_1$), et que le sectionneur de puissance à semiconducteur (11) ne ferme (chauffage 10 branché) que lorsque les sorties des deux comparateurs ($C_1$, $C_2$) se trouvent à l'autre état (H).

6. - Filtre à carburant selon l'une des revendications 4 et 5, caractérisé en ce que la tension d'alimentation des comparateurs ($C_1$, $C_2$) est limitée par une diode Zener ($Z_2$).

7. - Filtre à carburant selon l'une des revendications 4 à 6, caractérisé en ce que l'entrée de commande (16) du sectionneur de puissance à semiconducteur (11) est connectée, par l'intermédiaire d'une résistance ($R_6$), entre les résistances ($R_1$) d'une section de résistance à laquelle est appliquée la tension d'alimentation ($U_B$), et que la sortie du comparateur ($C_1$) et respectivement les sorties des comparateurs ($C_1$, $C_2$) sont reliées à l'entrée de commande (16) du sectionneur de puissance à semiconducteur (11).

8. - Filtre à carburant selon l'une des revendications 1 à 7, caractérisé en ce que tous les éléments électriques et respectivement électroniques qui commandent le sectionneur de puissance à semiconducteur (11) sont logés dans la tête de filtre (1) et alimentés en courant électrique par l'intermédiaire de branchements (15) associés au chauffage (10).

9. - Filtre à carburant selon l'une des revendications 1 à 8, caractérisé en ce que le sectionneur de puissance à semiconducteur (11) est en liaison thermoconductrice avec le chauffage par effet Joule (10) par l'intermédiaire d'éléments métalliques de la tête de filtre (1).

10. - Filtre à carburant selon l'une des revendications 1 à 8, caractérisé en ce que la tête de filtre (1) est réalisée en matière plastique.

11. - Filtre à carburant selon l'une des revendications 1 à 10, caractérisé en ce que la puissance dissipée du sectionneur de puissance à semiconducteur (11) utilisable pour le chauffage du carburant se situe dans l'ordre de grandeur d'environ 10 % de la puissance calorifique du chauffage par effet Joule (10).

12. - Filtre à carburant selon l'une des revendications 1 à 11, caractérisé en ce que le sectionneur de puissance à semiconducteur (11) et le chauffage par effet Joule (10) et/ou un élément métallique portant celui-ci sont soudés ensemble pour assurer le couplage thermique du sectionneur de puissance (11) et du chauffage par effet Joule (10).

EP 0 356 667 B1

FIG.1

10

FIG. 2